# EUROPÄISCHE PATENTANMELDUNG

(11) **EP 1 881 599 A1**
(43) Veröffentlichungstag der Anmeldung: **23.01.2008**
(21) Anmeldenummer: 07110469.9
(22) Anmeldetag: 18.06.2007
(51) Int. Cl.: H03F 3/08

(54) **Frequenzselektiver Transimpedanzverstärker**

(30) Priorität: 11.07.2006 DE 102006032102
(71) Anmelder: Siemens Building Technologies HVAC Products GmbH, 76437 Rastatt (DE)
(72) Erfinder: Spitznas, Armin, 76461 Muggensturm (DE)
(74) Vertreter: Maier, Daniel Oliver

(57) **Zusammenfassung**

Die Erfindung betrifft eine Transimpedanz-Verstärkerschaltung aufweisend einen Operationsverstärker mit einem invertierenden Eingang für das zu verstärkende Signal und einem Ausgang, der über einen Kopplungswiderstand mit dem invertierenden Eingang gekoppelt ist, dadurch gekennzeichnet, dass parallel zu dem Kopplungswiderstand zwei Widerstände in Serie geschaltet sind, wobei zwischen den Serienwiderständen und einem Massepotential ein Kondensator geschaltet ist.

## Beschreibung

Die vorliegende Erfindung betrifft eine Transimpedanz-Verstärkerschaltung, welche einen Operationsverstärker mit einem invertierenden Eingang für das zu verstärkende Signal und einen Ausgang aufweist, wobei der Ausgang über einen Kopplungswiderstand mit dem invertierenden Eingang gekoppelt ist.

Eine Verstärkerschaltung, der eingangs genannten Art ist beispielsweise aus der DE 101 45 203 B4 bekannt. Das zum Beispiel von einer Fotodiode detektierte Lichtsignal wird in einen elektrischen Strom gewandelt, der dem invertierenden Eingang eines Operationsverstärkers zugeführt wird. Das am invertierenden Eingang liegende Stromsignal wird dann in ein Spannungssignal umgewandelt, welches am Ausgang der Verstärkerschaltung bereitgestellt wird. Zur Einkopplung des Signalstroms ist eine Pufferschaltung vorgesehen, an die eine Äquivalenz-Widerstandschaltung angeschlossen ist. Dies ist jedoch schaltungstechnisch aufwendig.

Aus der DE 32 23 218 C2 ist es bekannt, in dem zwischen dem Eingang und dem Ausgang einer Verstärkerschaltung geschalteten Gegenkopplungszweig einen Spannungsteiler und einen Transistor vorzusehen, wobei der erste Widerstand des Spannungsteilers die Basis-Emitter-Strecke und der zweite Widerstand die Basis-Kollektor-Strecke des Transistors überbrückt.

Bei der Umwandlung eines sehr kleinen Eingangsstromsignals in ein Ausgangspannungssignal ist es im allgemeinen wünschenswert eine hohe Verstärkung zu erzielen, damit eine einfache Auswertung des Ausgangsspannungssignals möglich ist.

Wenn das Eingangsstromsignal aus einem Gleichanteil und einem im Verhältnis zum Gleichanteil viel kleineren Wechselanteil besteht, so wirkt sich der Gleichstromanteil bei der Signalverstärkung mit Hinblick auf die maximal mögliche Verstärkung als begrenzend aus. Dies ist jedoch insbesondere dann nachteilig, wenn nur der Wechselstromanteil für die Signalauswertung von Interesse ist.

Die Aufgabe der Erfindung besteht darin, eine frequenzselektive Transimpedanz-Verstärkerschaltung vorzuschlagen, die mit geringem schaltungstechnischem Aufwand realisiert werden kann.

Diese Aufgabe wird erfindungsgemäß durch eine Transimpedanz-Verstärkerschaltung mit den Merkmalen des Patentanspruches 1 gelöst.

Die erfindungsgemäße Transimpedanz-Verstärkerschaltung zeichnet sich dadurch aus, dass der Gegenkopplungszweig der Verstärkerschaltung einen Tiefpass aufweist, der zu einem Hochpassverhalten der Verstärkerschaltung führt, wobei Signale mit hohen Frequenzen eine stärkere Gegenkopplung als Signale mit tiefen Frequenzen erfahren. Mit der Erfindung kann die Verstärkung frequenzselektiv eingestellt werden, wobei Signale mit mittleren beziehungsweise hohen Frequenzen weitestgehend unabhängig von Signalen mit tiefen Frequenzen verstärkt werden können. Dadurch kann für den interessierenden Wechselanteil des Signals eine höhere Verstärkung erzielt werden als für den nicht interessierenden Gleichanteil des Signals. Die erfindungsgemäße frequenzselektive Verstärkerschaltung wird vorzugsweise für Fotodiodensignale verwendet, die bei einer verhältnismäßig hellen, aber konstanten Beleuchtung, Signale mit hohen Frequenzen und kleinen Amplituden liefern.

Weitere Vorteile der Erfindung ergeben sich aus der nachfolgenden Beschreibung eines Ausführungsbeispieles, welches in den Figuren dargestellt ist. Es zeigen:
- Figur 1: eine Verstärkerschaltung gemäss der Erfindung;
- Figur 2: das Ausgangssignal der Verstärkerschaltung.

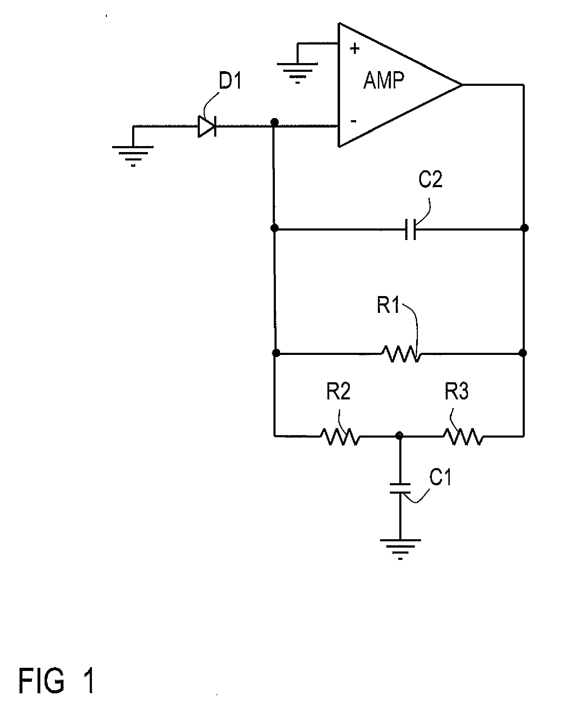

Bezug nehmend auf die Figur 1 weist die erfindungsgemässe Verstärkerschaltung einen Operationsverstärker AMP auf, an dessen invertierenden Eingang, dass von einer Fotodiode D1 stammende Stromsignal anliegt. Der andere Eingang des Operationsverstärkers ist an Massepotential angeschlossen. Der Ausgang des Operationsverstärkers ist über einen Kopplungswiderstand R1 mit dem invertierenden Eingang des Operationsverstärkers gekoppelt. Parallel zu dem Kopplungswiderstand R1 sind die Widerstände R2 und R3 in Reihe geschaltet. Zwischen den Serienwiderständen R2 und R3 und dem Massepotential ist ein Kondensator C1 geschaltet. Die untere Grenzfrequenz der Verstärkerschaltung kann über den Serienwiderstand R3 und die Kapazität C1 eingestellt werden. Dabei ist zu beachten, dass die Bandbreite der Verstärkerschaltung in etwa um den Faktor R1/R2 reduziert wird. Die Verstärkung für tiefe Frequenzen beziehungsweise für den Gleichanteil kann über die Parallelschaltung von R1 mit den Serienwiderständen R2 und R3 eingestellt werden. Die Verstärkung für mittlere beziehungsweise hohe Frequenzen kann durch den Kopplungswiderstand R1 eingestellt werden. Parallel zu dem Kopplungswiderstand R1 kann ein weiterer Kondensator C2 geschaltet werden. Dieser ist doch für die Funktion der Verstärkerschaltung nicht zwingend erforderlich.

Die Kapazität des Kondensators C2 ist auf die gewünschte Durchlassfrequenz der Verstärkerschaltung und den Kopplungswiderstand R1 entsprechend abzustimmen und bestimmt dann die obere Grenzfrequenz der Verstärkerschaltung.

Für die in Figur 1 dargestellte Transimpedanz-Verstärkerschaltung wurde vorzugsweise folgende Dimensionierung gewählt. Der Kondensator C1 weist beispielsweise eine Kapazität von 100 Nano-Farad und der Kondensator C2 eine Kapazität von 10 Piko-Farad auf. Der Kopplungswiderstand R1 weist einen Widerstandswert von beispielsweise 1 Mega-Ohm und die Serienwiderstände R2 und R3 weisen Widerstandswerte von beispielsweise 100 Kilo-Ohm beziehungsweise 10 Kilo-Ohm auf. Diese Dimensionierung des Ausführungsbeispieles bewirkt bei einer Bandbreite desOperationsverstärkers von beispielsweise 1 Mega-Hertz eine Reduktion um den Faktor 10 auf 100 Kilo-Hertz. Selbstverständlich kann auch eine andere Dimensionierung für die Transimpedanz-Verstärkerschaltung gewählt werden.

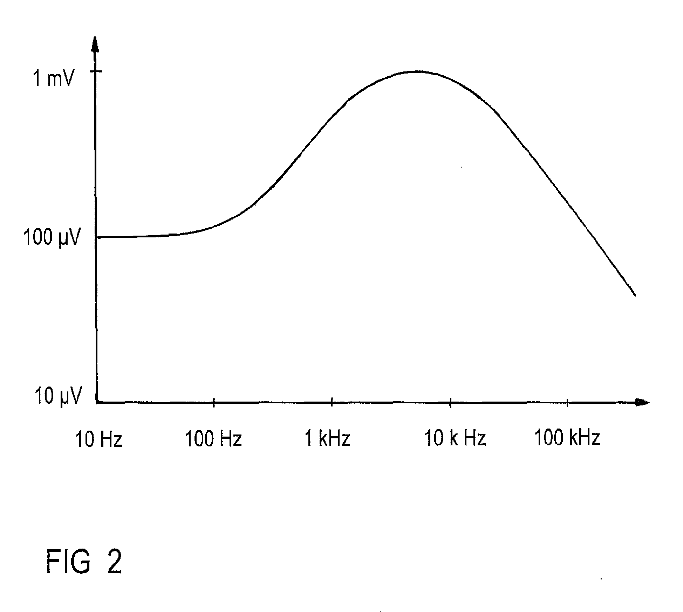

Figur 2 zeigt beispielhaft das für die in Figur 1 dargestellte Verstärkerschaltung erhaltene Ausgangsspannungssignal in Abhängigkeit von der Frequenz bei einem Eingangsstromsignal, welches einen Gleichanteil von 1 Mikro-Ampere und einen Wechselanteil von 1 Nano-Ampere aufweist.

## Patentansprüche

1. Transimpedanz-Verstärkerschaltung aufweisend einen Operationsverstärker (AMP) mit einem invertierenden Eingang für das zu verstärkende Signal und einem Ausgang, der über einen Kopplungswiderstand (R1) mit dem invertierenden Eingang gekoppelt ist, **dadurch gekennzeichnet, dass** parallel zu dem Kopplungswiderstand (R1) zwei Widerstände (R2, R3) in Serie geschaltet sind, wobei zwischen den Serienwiderständen (R2, R3) und einem Massepotential ein Kondensator (C1) geschaltet ist.

2. Transimpedanz-Verstärkerschaltung nach Anspruch 1, **dadurch gekennzeichnet, dass** parallel zu dem Kopplungswiderstand (R1) ein Kondensator (C2) geschaltet ist.

3. Transimpedanz-Verstärkerschaltung nach Anspruch 2, **dadurch gekennzeichnet, dass** der parallel zu dem Kopplungswiderstand (R1) geschaltete Kondensator (C2) eine Kapazität in der Grössenordnung Nano-Farad und der zwischen den Serienwiderständen (R2, R3) und dem Massepotential geschaltete Kondensator (C1) eine Kapazität in der Grössenordnung Piko-Farad aufweist.

4. Transimpedanz-Verstärkerschaltung nach einem der Ansprüche 1 bis 3, **dadurch gekennzeichnet, dass** der Kopplungswiderstand (R1) einen Widerstandswert in der Grössenordnung Mega-Ohm und die Serienwiderstände (R2, R3) Widerstandswerte in der Grössenordnung Kilo-Ohm aufweisen.

5. Transimpedanz-Verstärkerschaltung nach einem der vorhergehenden Ansprüche, **dadurch gekennzeichnet, dass** diese zur Verstärkung eines Fotodiodensignals (D1) verwendet wird.
